Europäisches Patentamt

European Patent Office

Office européen des brevets

(19)

(11) Publication number: **0 165 462**
**B1**

(12) **EUROPEAN PATENT SPECIFICATION**

(45) Date of publication of patent specification: **09.08.89**

(51) Int. Cl.⁴: **H 04 Q 11/04, H 03 M 7/38**

(21) Application number: **85105919.6**

(22) Date of filing: **14.05.85**

(54) Digital switch module.

(30) Priority: **29.05.84 JP 107516/84**

(43) Date of publication of application:
**27.12.85 Bulletin 85/52**

(45) Publication of the grant of the patent:
**09.08.89 Bulletin 89/32**

(84) Designated Contracting States:
**BE CH DE FR GB IT LI NL SE**

(56) References cited:
**EP-A-0 028 104**
**US-A-3 825 924**
**US-A-4 155 070**
**US-A-4 399 534**

**INTERNATIONAL CONFERENCE ON COMMUNICATIONS, Seattle, WA., 8th-12th June 1980, vol. 2 of 3, paper 20.2, pages 1-5, IEEE, New York, US; P.V. COVERDALE: "Transmission performance of telephone connections involving digital signal processing devices"**

(73) Proprietor: **FUJITSU LIMITED**
**1015, Kamikodanaka Nakahara-ku Kawasaki-shi Kanagawa 211 (JP)**

(72) Inventor: **Takahashi, Atsuhisa**
**5-3, Nijigaoka 1-chome Asao-ku Kawasaka-shi Kanagawa 215 (JP)**
Inventor: **Nara, Takashi**
**15-5-701, Kawabecho Hodogaya-ku Yokohama-shi Kanagawa 240 (JP)**
Inventor: **Murayama, Masami**
**39-6, Umegaoka Midori-ku Yokohama-shi Kanagawa 227 (JP)**
Inventor: **Takeichi, Hiroaki**
**63, Kuritaya Kanagawa-ku Yokohama-shi Kanagawa 221 (JP)**

(74) Representative: **Lehn, Werner, Dipl.-Ing. et al Hoffmann, Eitle & Partner Patentanwälte Arabellastrasse 4 D-8000 München 81 (DE)**

(56) References cited:

**PATENTS ABSTRACTS OF JAPAN, vol. 2, no. 35, 9th March 1978, page 12671 E 77; & JP - A - 53 903 (NIPPON DENKI K.K.) 07-01-1978**

**IEEE COMMUNICATIONS MAGAZINE, vol. 20, no. 6, November 1982, pages 15-23, New York, US; E.A. MUNTER: "Digital switch digitalks"**

**1978 INTERNATIONAL ZURICH SEMINAR ON DIGITAL COMMUNICATIONS, Digital Transmission and Switching in Local Networks, 7th-9th March 1978, Zurich, paper A5, pages 1-6; H.G. ALLES: "An intelligent network processor for a digital central office"**

## Description

The present invention relates to a digital switch module for effecting mutual coding between digital signals obtained through different kinds of encoding laws for digital coding of analog signal in a digital switching system for switching on a time slot basis.

A conventional digital switching system digitizes a voice signal and switches it on the time slot basis and is also capable of switching the signal including data.

For example, as indicated in "CCITT Yellow Book, Volume III—Fascicle III 3, Digital Networks Transmission Systems and Multiplexing Equipment. Recommendations G.701—G.941, VIIth Plenary Assembly, Geneva 10—21 November 1980", the A-law and µ-law described in the CCITT recommdendation G. 711 are known as encoding laws for digitizing the voice signal. Since the PCM code signals digitized on the basis of the respective encoding laws do not have mutual compatibility, if a switching network is formed including the A-law encoding region and the µ-law encoding region, conversion of the encoding law is required in the respective regions for smooth switching in the network as a whole.

Basically the A-law encoding region and the µ-law encoding region are separated correspondingly and for the international communication between these regions, the signal is once converted to an analog signal for matching and then the signal is encoded on the basis of the object digital encoding law for the communication.

As explained above, it is illogical, in the recent trend of digitization in communication network and switching systems, to employ a system where the digital signal is intentionally converted to an analog signal for the communication between the regions each of which is respectively employing different kinds of digital encoding laws, and it is certainly desirable that the encoding laws are converted for communication while the digital signal is used.

For such conversion of encoding laws, it may be considered to provide an exclusive code converter at the desired location of communication line. In this case, the A-law is generally adapted, as described in the CCITT Rec. G. 732, to the primary PCM system operating at 2048 kbits/s, while the µ-law to the primary PCM system operating at 1544 kbits/s as described in the CCITT Rec. G. 733. The former has the capacity of 30 channels per system and accommodates 4 systems, while the latter has the capacity of 24 channels per system and accommodates 5 systems. These each have the capacity of 120 channels in total and the code conversion is carried out through the interface between them. A number of code converters to be provided is determined in accordance with channel capacity. Accordingly, the system becomes uneconomical in accordance with the channel capacity and since it is not each to effect data conversion for each channel, it is impossible to transfer the data which requires bit sequence independence and bit transparency, namely the data which does not require the code conversion in depending on the A-law or µ-law between the A-law region and µ-law region. In other words, it is impossible to realise the switching on the time sharing basis while the lines transmitting both voice signals and data reaccommodated.

A paper entitled "Transmission Performance of Telephone Connections involving Digital Signal Processing Devices" by P. V. Coverdale, published in the proceedings of the International Conference on Communications in June 1980 discloses a purely mathematical treatment of an international digital connection including an A/Mu law converter. This disclosure relates more to a feasibility study of law conversion rather than representing a practical system and contains no discussion of the construction of such a converter. Furthermore, the illustrated system is inflexible and is restricted to the single conversion according to the desired law.

From US—A—3825924 a method of law conversion is known which is carried out by means of logical circuits. As such this system is also not flexible and is limited to a single conversion. ·

From JP—A—53903 a ROM memory device is known which is used for conversion between digital code words. Such a device is used as a digital pad for converting a digital signal from one level to another. Such devices are used as attenuators in transmission systems but have not been incorporated in law conversion devices.

It is a first object of the present invention to provide a digital switch module which realize conversion control between the digital encoding law signals for switching not only the voice signal but also the data in the digital switching system through an economical constitution and very flexible control.

It is a second object of the present invention to previously store the conversion data corresponding to the mutual conversion pattern of each kind of digital encoding law signal in the memory for all input digital signals and to read and output conversion between the digital encoding law signals by said memory for each time slot of output highway in viewing of matching with the digital encoding law signals corresponding respectively to the originating side and terminating side.

It is a third object of the present invention to execute adjustment of transmission loss for level matching simultaneously with mutual conversion of different kinds of digital encoding laws.

The object of the present invention is solved by a digital switch module for time division switching between channels arranged to effect digital code conversion corresponding to the channels including conversion accommodating said digital channels in different kinds of encoding laws for digitizing voice signals characterized by a conversion data memory storing conversion data in said different kinds of encoding laws and being directly inserted into a speech highway within the digital switch module and by a control memory selectively designating the conversion data of specified encoding laws for each time slot

3

on an output highway in accordance with input and output side information obtained by setting a channel path.

Optionally, according to the present invention, data can be sent or received immediately after or before the conversation by making conversation between the terminals in the different encoding laws and sending the control signal for data transmission.

Moreover, the present invention can also be adapted to control of attenuation value and realises level matching for connection of different switching networks.

These and other objects and features of the present invention will become apparent from the following description of a preferred embodiment thereof with reference to the accompanying drawings, in which:

Fig. 1 indicates outline of an embodiment of the present invention,

Fig. 2 is an example of an embodiment of the present invention adapted to a digital switching system of the time switch—space switch—time switch structure,

Fig. 3 is a further detailed connection digaram of digital code encoding laws conversion memory and its control memory,

Fig. 4 shows a profile of conversion in encoding laws by the encoding laws conversion memory, and

Fig. 5 shows a switching network.

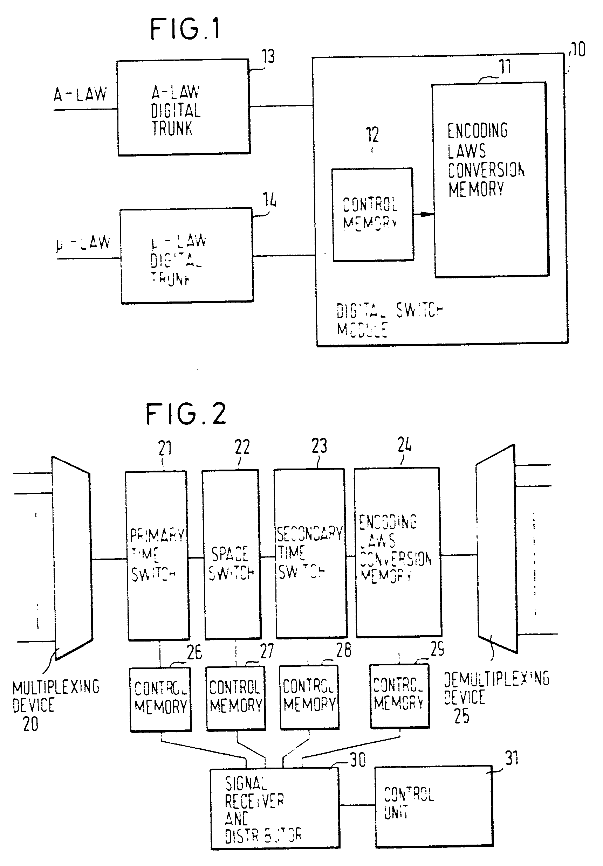

Fig. 1 shows a block diagram of one embodiment of the present invention, employing a digital switch module 10 which is capable of switching the PCM signals of both A-law and μ-law. This digital switch module 10 is provided with a digital code encoding laws conversion memory 11 which controls conversion between the A-law and μ-law corresponding to the time slot and a control memory 12. The digital code encoding laws conversion memory 11 is formed by a read only memory (ROM), etc. and stores the conversion data for converting encoding laws. The control data is written to the control memory 12 corresponding to the time slot, the storing region of conversion data of the digital code encoding laws conversion memory 11 which controls conversion or no conversion of encoding laws between the A-law and μ-law is designated by the read control data, and conversion is no conversion between encoding laws are controlled in unit of time slot for time division switching. 13 is a digital terminal of A-law and 14 is a digital terminal of μ-law.

Fig. 2 is a block diagram of essential parts of the embodiment of the present invention adapted to a digital switch in the structure of the time switch—space switch—time switch. 20 is a multiplexer, 21 is a primary time switch, 22 is a space switch, 23 is a secondary time switch, 24 is a digital code encoding laws conversion memory consisting of read only memory (ROM), 25 is a demultiplexer, and 26~29 are control memories.

The control data is written to the control memories 26~28 from a control unit 31 through a signal receiver and distributor 30 and the primary time switch 21, space switch 22 and secondary time switch 23 are controlled as is well known in accordance with said control data for the time division switching operation.

The control data which controls the conversions such as A-law to μ-law, μ-law to A-law, A-law to A-law and μ-law to μ-law, etc. and attenuation value is written to the control memory 29 in correspondence with the time slot, and access to the digital code encoding laws conversion memory 24 is made from such control memory 29 with the PCM signal corresponding to the time slot used as the address. Since the conversion data in the region of digital code encoding laws conversion memory 24 designated by the control data is read in accordance with the PCM signal in the time slot on the output highway, control for conversion or not conversion of encoding laws is carried out in unit of time slot.

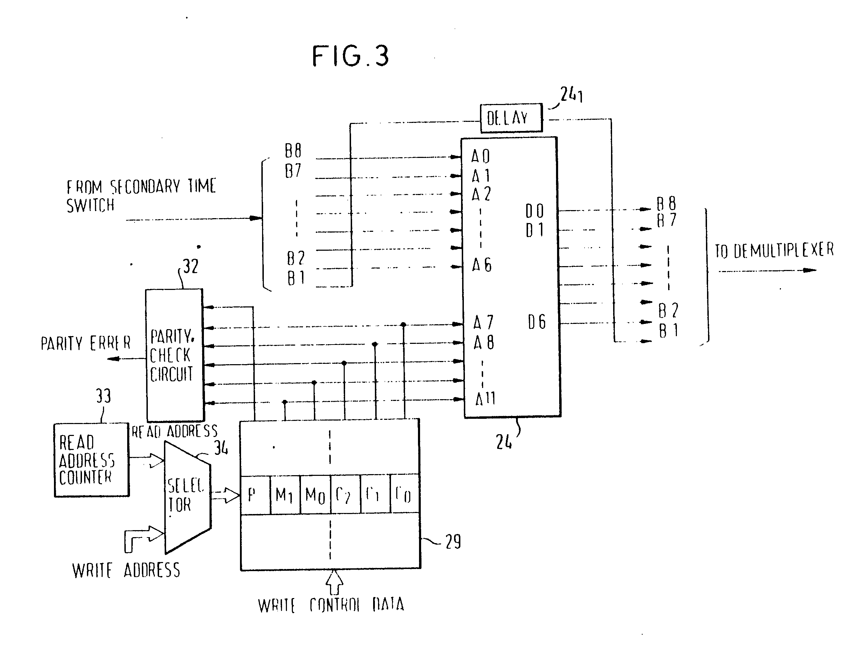

Fig. 3 shows further detail of the constitution of the digital code encoding laws conversion memory and control memories in the embodiment of the present invention. 24 is a digital code encoding law conversion memory, 29 is a control memory, 32 is a parity check circuit, 33 is an address counter, and 34 is an input selector. The digital code encoding laws conversion memory 24 is constituted, for example, by the read only memory (ROM) having the storing capacity of 7 bits×4 K. With the 7 bits B2 B8 among 8 bits B1 B8 of the PCM signal for each timeslot on the output highway of the second time switch 23 considered as the partial addresses A0 A6 and the control data of 5 bits read from the control memory 29 as the remaining addresses A7. All, access can be made to the digital code encoding laws conversion memory 24 by the address signal of 12 bits. The PCM signal of 8 bits B1~B8 to be applied to the demultiplexer 25 can be obtained from the read data D0~D6 of 7 bits among the read data of 8 bits of the digital code encoding laws conversion memory 24 and the PCM signal of 1 bit B1 of time slot on the output highway. In case a degree of multiplex in the digital switch module is determined, for example, as 1024, the control memory 29 is constituted by a random access memory having the memory capacity of 6 bits×1,024 and the attenuation value is designated by the pad of 3 bits and the control bits $C_0$, $C_1$, $C_2$ and conversion or no conversion in the coding laws is designated by the pad of 2 bits and mode bits $M_0$, $M_1$. P represents a parity bit. Table 1 shows the relation between the decision value number of an A-law input signal and a corresponding character signal of 7 bits (B2~B8), Table 2 shows relation between decision value number of μ-law input signal and corresponding character signal of 7 bits (B2~B8), Table 3 shows an example of relation between pad control bits $C_0$, $C_1$, $C_2$ and attenuation value (dB), and Table 4 shows an example of relation between pad mode bits $M_0$, $M_1$ and conversion in coding laws. The values indicated in Table 1 and Table 2 depend on said CCITT Recommendation G.711.

4

TABLE 1

A-law input

| No. | B2 (A6 | B3 | B4 | B5 | B6 | B7 | B8 A0) |
|---|---|---|---|---|---|---|---|
| 128 | 1 | 1 | 1 | 1 | 1 | 1 | 1 |
| ∫ | | | | ∫ | | | |
| 113 | 1 | 1 | 1 | 0 | 0 | 0 | 0 |
| ∫ | | | | ∫ | | | |
| 97 | 1 | 1 | 0 | 0 | 0 | 0 | 0 |
| ∫ | | | | ∫ | | | |
| 81 | 1 | 0 | 1 | 0 | 0 | 0 | 0 |
| ∫ | | | | ∫ | | | |
| 65 | | 0 | 0 | 0 | 0 | 0 | 0 |
| ∫ | | | | ∫ | | | |
| 49 | 0 | 1 | 1 | 0 | 0 | 0 | 0 |
| ∫ | | | | ∫ | | | |
| 33 | 0 | 1 | 0 | 0 | 0 | 0 | 0 |
| ∫ | | | | ∫ | | | |
| 2 | 0 | 0 | 0 | 0 | 0 | 0 | 1 |
| 1 | 0 | 0 | 0 | 0 | 0 | 0 | 0 |

Note: The actual character signals on the PCM channel are obtained by inverting the even bits of the above table.

TABLE 2

μ-law input

| No. | B2 (A6 | B3 | B4 | B5 | B6 | B7 | B8 A0) |
|---|---|---|---|---|---|---|---|
| 127 | 0 | 0 | 0 | 0 | 0 | 0 | 0 |
| ∫ | | | | ∫ | | | |
| 112 | 0 | 0 | 0 | 1 | 1 | 1 | 1 |
| ∫ | | | | ∫ | | | |
| 96 | 0 | 0 | 1 | 1 | 1 | 1 | 1 |
| ∫ | | | | ∫ | | | |
| 80 | 0 | 1 | 0 | 1 | 1 | 1 | 1 |
| ∫ | | | | ∫ | | | |
| 64 | 0 | 1 | 1 | 1 | 1 | 1 | 1 |
| ∫ | | | | ∫ | | | |
| 48 | 1 | 0 | 0 | 1 | 1 | 1 | 1 |
| ∫ | | | | ∫ | | | |
| 32 | 1 | 0 | 1 | 1 | 1 | 1 | 1 |
| ∫ | | | | ∫ | | | |
| 16 | 1 | 1 | 0 | 1 | 1 | 1 | 1 |
| ∫ | | | | ∫ | | | |
| 0 | 1 | 1 | 1 | 1 | 1 | 1 | 1 |

For the time slot where the A-law is converted to the μ-law and attenuation value is set to 0, the control data to be written to the control memory 29 as P, $M_1$, $M_0$, $C_2$, $C_1$, $C_0$ should be "001000" and for the time slot where the A-law is not converted and attenuation value is set to 3 dB, the data to be written to the control memory 29 should be "100011". The parity bit P is used for the odd parity.

An address counter 33 generates a readout address by counting clock signals. For example, the address of control memory 29 is applied sequentially to the control memory 29 through the selector 34 and the control data P, $M_1$, $M_0$, $C_2$, $C_1$, $C_0$ corresponding to the time slot are read. As explained above, this control data becomes the read-out addresses A7~A11 of the digital code encoding laws conversion memory 24, the data of 7 bits B2~B8 among the 8 bits B1~B8 sent from the secondary time switch 23 become the read-out addresses A0~A6 of the digital code encoding laws conversion memory 24 and the data of 7 bits D0~D6 indicating conversion or no conversion or attenuation value are read from the region

5

designated by data within the region designated by the control data. The control data read from the control memory 29 is applied to a parity check circuit for parity check of control data. When parity error is detected, a parity error signal is sent to a control unit 31, etc. through the signal receiver and distributor 30 and thereby the procedures for suspending use of such time slot are taken. The write address sent from the control unit 31 through the signal receiver and distributor 31 is applied to the control memory 29 through the selector 34 and simultaneously the write control data is sent to the control memory 29 for writing control data corresponding to the time slot. Thereby, conversion or no conversion of encoding laws and attenuation value can be controlled dynamically in correspondence with the time slot.

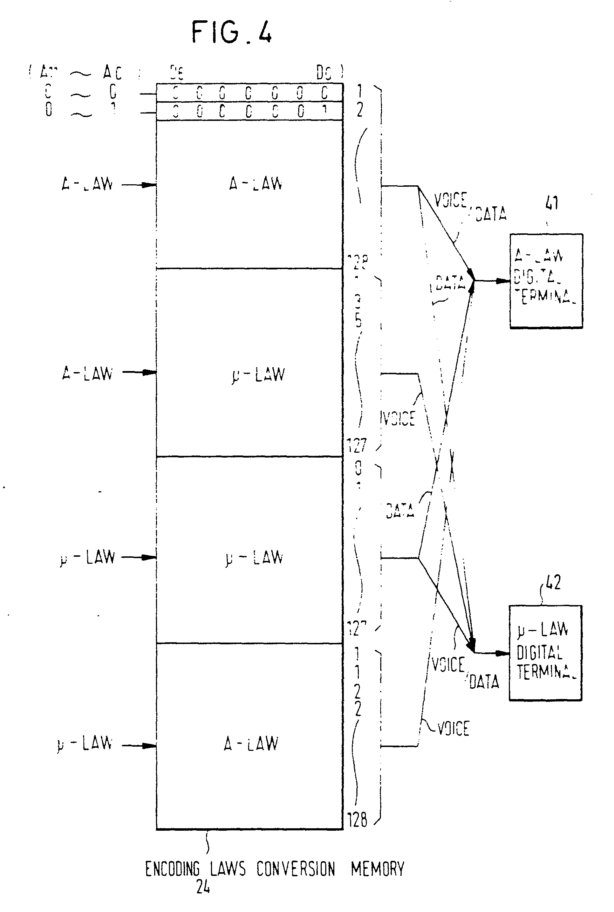

Fig. 4 shows the principle of conversion in coding laws and attenuation, wherein the regions for conversion or no conversion in coding laws of (A-law)—(A-law), (A-law)—(µ-law), (µ-law)—(µ-law), (µ-law)—(A-law) shown in Table 3 are designated by the pad mode bits $M_1$, $M_0$ and simultaneously attenuation value shown in Table 4 is determined by the pad control bits $C_2$, $C_1$, $C_0$. 41 is a terminal for A-law and 42 is a terminal for µ-law.

TABLE 3

Mode designation

| Conversion of encoding law | M1 (A11) | M0 (A10) |
|---|---|---|
| A-LAW→A-LAW | 0 | 0 |
| A-LAW→µ-LAW | 0 | 1 |
| µ-LAW→µ-LAW | 1 | 0 |
| µ-LAW→A-LAW | 1 | 1 |

TABLE 4

Pad value designation

| Attenuation (dB) | $C_2$ (A9) | $C_1$ (A8) | $C_0$ (A7) |
|---|---|---|---|
| 0 | 0 | 0 | 0 |
| 1 | 0 | 0 | 1 |
| 2 | 0 | 1 | 0 |
| 3 | 0 | 1 | 1 |
| 4 | 1 | 0 | 0 |
| 7 | 1 | 0 | 1 |
| 10 | 1 | 1 | 0 |
| ∞ | 1 | 1 | 1 |

If the region of conversion in (A-law)—(A-law) is designated by the pad mode bits $M_1$, $M_0$, ("00") for a certain time slot and attenuation value 0dB is designated by the pad control bits $C_2$, $C_1$, $C_0$ "000"), the PCM signal input as the read-out address is read as the same PCM signal and the conversion between coding laws is not carried out. Therefore, the voice signal and data can be seen and received for the terminals 41 of A-law. Since the data transmission is carried out using the digital signal (PCM signal), the conversion of (A-law)—(µ-law) or (µ-law)—(A-law) is impossible. Accordingly, since the conversion of coding law is not carried out for the terminal of µ-law, only the data is sent and received.

In a certain time slot where the region for conversion of (µ-law)—(A-law) is designated by the pad mode bits $M_1$, $M_0$ ("11"), the PCM signal input as the read-out address is converted into the PCM signal of µ-law and is read. Thereby, only the voice signal is sent and received for the terminal 41 of A-law and transmission and reception of data are impossible because conversion of coding laws is carried out and data is also converted. Table 5 partly shows, in bit level, the contents of address signal of encoding laws inversion memory 24 consisting of the read only memory (ROM) shown in Fig. 4 and the data signal in the memory. Conversion to μ-law from A-law or to A-law from μ-law is carried out on the basis of the aforementioned CCITT recommendation G.711.

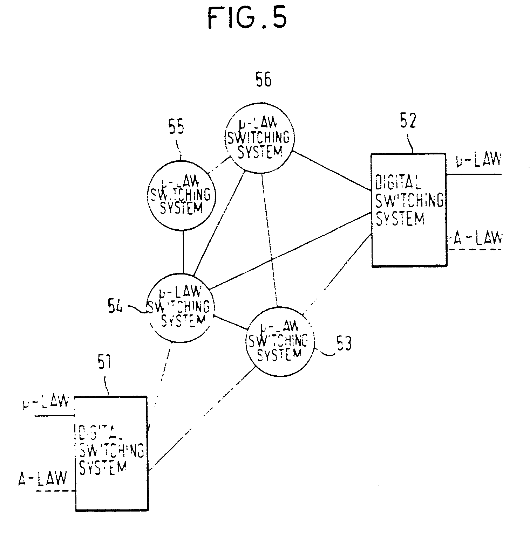

Fig. 5 is a switching network, wherein 51, 52 are digital switching systems which are capable of switching the signal for both A-law and μ-law and are provided with the digital code encoding laws conversion memory for conversion of coding laws as explained above. 53~56 are digital switching systems (Dual-Standard Switches), for example, of the μ-law. Connection of PCM network and switching network of A-law and μ-law can be realized by providing the digital switch modules 51, 52 which are capable of switching the PCM signals in both coding laws for the other network to the switching network consisting of the digital switching system of μ-law. Such connection can also be realized even in case the switching network is formed using the digital switch modules of A-law.

TABLE 5

| | | ROM address | | | | | ROM data (contents) | | |
|---|---|---|---|---|---|---|---|---|---|
| | A11 | A10 | A9 A8 A7 | A6 ~ A0 | | D6 | ~ | D0 | |
| A-law ↓ A-law | 0 | 0 | 0 0 0 | 0 ~ 0 | → | 0 | ~ | 0 | A-law 1 |
| | 0 | 0 | 0 0 0 | 0 ~ 11 | → | 0 | ~ | 0 1 | A-law 2 |
| | 0 | 0 | 0 0 0 | 0 ~ 11 | → | 1 | ~ | 1 1 | A-law 128 |
| | 0 | 0 | 0 0 1 | 0 ~ 0 | → | 0 | ~ | 0 | 1dB down of A-law |
| | 0 | 0 | 0 0 1 | 1 ~ 1 | → | ( | | ) | 1dB down of A-law 1 |
| | ∫ | | ∫ | ∫ | | | ∫ | | |
| | 0 | 0 | 1 1 1 | 0 ~ 0 | → | (A-law silent pattern) | | | 00 pad of A-law 1 |
| | 0 | 0 | 1 1 1 | 1 ~ 1 | → | (A-law silent pattern) | | | 00 pad of A-law 1 |
| A-law ↓ μ-law | 0 | 1 | 0 0 0 | 0 ~ 0 | → | 1 1 1 1 1 1 0 | | | μ-law 1 |
| | 0 | 1 | 0 0 0 | 0 ~ 01 | → | 1 1 1 1 1 0 1 | | | μ-law 3 |

Note: This table contents is one example to explain the conversion principle.

As explained previously, the present invention provides the memory for code conversion 24 storing the conversion data for encoding laws of A-law and μ-law and attenuation data and the control memory 29 which designates conversion of encoding laws by such memory for code conversion 24 or attenuation value for each time slot and thereby controls conversion or no conversion in encoding laws corresponding to the time slot by the control memory 29 even in case the PCM signals of different encoding laws exist on the highway. Accordingly, it is possible to dynamically control the conversion in encoding laws and to send or receive the data immediately after the conversation by making communication between terminals and sending the control signal for data transmission. The memory for code conversion 24 can also be used for attenuation value control and realizes easily the level matching for connection of different types of switching networks.

## Claims

1. A digital switch module (10) for time division switching between channels arranged to effect digital code conversion corresponding to the channels including conversion accommodating said digital channels in different kinds of encoding laws for digitizing voice signals

   characterized by a conversion data memory (11) storing conversion data in said different kinds of encoding laws and being directly inserted into a speech highway within the digital switch module (10) and by a control memory (12) selectively designating the conversion data of specified encoding laws for each time slot on an output highway in accordance with input and output side information obtained by setting a channel path.

2. A digital switch module (10) according to claim 1 characterized in that said conversion data memory (11) previously stores level attenuation data and said control memory (12) includes means for designating an attenuation value indicating which of the level attenuation data is to be used during each of the time slots.

3. A digital switch module according to any one of claims 1 or 2, wherein said conversion data memory (11) is arranged to store data corresponding to patterns of every possible combination required for switching and connection with the digital signal for each time slot on the speech highway considered as partial addresses and the control data read from said control memory (12) as the remaining addresses.

4. A digital switch module according to any one of claims 1 to 3, wherein said conversion data memory (11) is constituted by read-only-memory.

5. A digital switch module according to any one of claims 1 to 4, wherein said conversion data memory (11) and control memory (12) are arranged to execute processing under control of a control unit (31) provided within an associated digital switching system.

6. A digital switch module according to any one of claims 1 to 5, wherein said control memory (12) is arranged to accept write addresses and write data sent from a control unit (31) of an associated digital switching system, reads the data written corresponding to the address of said control memory (12) in accordance with a read address generated by an address counter (33) and supplies read-out data such as address information for said conversion data memory (11).

7. A digital switch module according to any one of claims 1 to 6, wherein said conversion data memory (11) is arranged to store data of the same kind as the encoding law for digitalizing a voice signal and conversion data for encoding laws in different kinds, and thereby to convert signals in accordance with the encoding law of an output highway for voice information obtained by digitizing said voice signal and to read the data of the encoding law of the same type for data information which is intrinsically a digital signal and to output such readout data to the output highway.

**Patentansprüche**

1. Digitales Vermittlungsmodul (10) zum zeitgeteilten Schalten zwischen Kanälen, das zum Ausführen einer digitalen Code-Umsetzung entsprechend den Kanälen ausgebildet ist, wobei die Umsetzung eine Anpassung der digitalen Kanäle in unterschiedlichen Codierungsgesetzen zum Digitalisieren von Sprechsignalen erlaubt, gekennzeichnet durch einen Umsetzungsdatenspeicher (11), der Umsetzungsdaten in den verschiedenen Codierungsgesetz ( 'peichert und direkt in eine Sprechvielfachleitung innerhalb des digitalen Vermittlungsmoduls (10) eingesetzt ist, und durch einen Steuerspeicher (12), der selektiv die Umsetzungsdaten von spezifizierten Codierungsgesetzen für ein Zeitfach auf einer Ausgangsvielfachleitung entsprechend Eingangs- und Ausgangsseitendaten bestimmt, die durch Einstellen eines Kanalpfads erhalten werden.

2. Digitales Vermittlungsmodul (10) nach Anspruch 1, dadurch gekennzeichnet, daß der Umsetzungsdatenspeicher (11) vorher Pegeldämpfungsdaten speichert und daß der Steuerspeicher (12) Mittel zum Bestimmen eines Dämpfungswertes enthält, der andeutet, welche der Pegeldämpfungsdaten während jeder der Zeitfächer benutzt werden.

3. Digitales Vermittlungsmodul nach einem der Ansprüche 1 oder 2, dadurch gekennzeichnet, daß der Umsetzungsdatenspeicher (11) zum Speichern von Daten entsprechend Mustern von jeder möglichen zum Schalten von und Verbinden mit dem digitalen Signal für jedes Zeitfach auf der in Betracht gezogenen Sprechvielfachleitung benötigten Kombination als Teiladressen und der aus dem Steuerspeicher (12) gelesenen Steuerdaten als die restlichen Adressen ausgebildet ist.

4. Digitales Vermittlungsmodul nach einem der Ansprüche 1 bis 3, dadurch gekennzeichnet, daß der Umsetzungsdatenspeicher (11) aus einem Festwertspeicher (ROM) besteht.

5. Digitales Vermittlungsmodul nach einem der Ansprüche 1 bis 4, dadurch gekennzeichnet, daß der Umsetzungsdatenspeicher (11) und Steuerspeicher (12) ausgebildet sind, um Vorgänge unter der Kontrolle einer innerhalb eines zugeordneten digitalen Schaltsystems vorgesehen Steuereinheit (31) durchzuführen.

6. Digitales Vermittlungsmodul nach einem der Ansprüche 1 bis 5, dadurch gekennzeichnet, daß der Steuerspeicher (12) zum Annehmen von Schreibadressen und Schreibdaten, die von einer Steuereinheit (31) eines zugeordneten digitalen Schaltsystems gesendet worden sind, zum Lesen der entsprechend der Adresse des Steuerspeichers (12) geschriebenen Daten entsprechend einer durch einen Adressenzähler (33) erzeugten Leseadresse und zum Abgeben von ausgelesenen Daten wie Adressendaten für den Übersetzungsdatenspeicher (11) ausgebildet ist.

7. Digitales Vermittlungsmodul nach einem der Ansprüche 1 bis 6, dadurch gekennzeichnet, daß der Umsetzungsdatenspeicher (11) zum Speichern von Daten der gleichen Sorte wie das Codierungsgesetzt zum Digitalisieren eines Sprechsignals und von Übersetzungsdaten für Codierungsgesetze in unterschiedlichen Sorten und dadurch zum Umsetzen von Signalen entsprechend dem Codierungsgesetz einer Ausgangvielfachleitung für durch Digitalisieren des Sprechsignals erhaltenen Sprechinformationen, und zum Lesen der Daten des Codierungsgesetzes der gleichen Sorte für Dateninformationen, die eigentlich ein Digitalsignal sind, und zum Abgeben solcher ausgelesener Daten an die Ausgangsvielfachleitung ausgebildet ist.

**Revendications**

1. Un module de commutation numérique (10) pour la commutation temporelle entre des canaux, conçu pour effectuer une conversion de code numérique correspondant aux canaux, comprenant une conversion qui permet d'accepter les canaux numériques avec différentes sortes de lois de codage pour la numérisation de signaux vocaux,
caractérisé par une mémoire de données de conversion (11) qui enregistre des données de conversion pour les différentes sortes de lois de codage, et qui est directement intercalée dans un bus de parole, à l'intérieur du module de commutation numérique (10), et par une mémoire de commande (12) qui désigne sélectivement les données de conversion de lois de codage spécifiées, pour chaque intervalle de temps sur un bus de sortie, conformément à une information du côté d'entrée et du côté de sortie qui est obtenue par l'établissement d'un itinéraire pour les canaux.

2. Un module de commutation numérique (10) selon la revendication 1, caractérisé en ce que des données d'atténuation de niveau ont été enregistrées préalablement dans la mémoire de données de conversion (11), et la mémoire de commande (12) comprend des moyens pour désigner une valeur d'atténuation indiquant celles des données d'atténuation de niveau qui doivent être utilisées pendant chacun des intervalles de temps.

3. Un module de commutation numérique selon l'une quelconque des revendications 1 ou 2, dans lequel la mémoire de données de conversion (11) est conçue pour enregistrer des données correspondant à des configurations de chaque combinaison possible qui est nécessaire pour la commutation du signal numérique et la connexion avec ce signal numérique pour chaque intervalle de temps sur le bus de parole considéré, comme des adresses partielles, tandis que les données de commande qui sont lues dans la mémoire de commande (12) sont enregistrées comme les adresses restantes.

4. Un module de commutation numérique selon l'une quelconque des revendications 1 à 3, dans lequel la mémoire de données de conversion (11) est constituée par une mémoire morte.

5. Un module de commutation numérique selon l'une quelconque des revendications 1 à 4, dans lequel la mémoire de données de conversion (11) et la mémoire de commande (12) sont conçues de façon à accomplir un traitement sous la commande d'une unité de commande (31) qui est incorporée dans un système de commutation numérique associé.

6. Un module de commutation numérique selon l'une quelconque des revendications 1 à 5, dans lequel la mémoire de commande (12) est conçue de façon à accepter des adresses d'écriture et des données d'écriture qui sont émises par une unité de commande (31) d'un système de commutation numérique associé, elle lit les données écrites correspondant à l'adresse de la mémoire de commande (12), conformément à une adresse de lecture qui est produite par un compteur d'adresse (33), et elle fournit les données lues en tant qu'information d'adresse pour la mémoire de données de conversion (11).

7. Un module de commutation numérique selon l'une quelconque des revendications 1 à 6, dans lequel la mémoire de données de conversion (11) est conçue de façon à enregistrer des données de la même sorte que la loi de codage pour la numérisation d'un signal vocal, et des données de conversion pour des lois de codage de différentes sortes, et par conséquent à convertir des signaux conformément à la loi de codage d'un bus de sortie pour l'information vocale qui est obtenue par numérisation du signal vocal, et de façon à lire les données de la loi de codage du même type pour une information de données qui consiste de façon intrinsèque en un signal numérique, et à émettre ces données lues vers le bus de sortie.

## FIG.1

A-LAW ——— [A-LAW DIGITAL TRUNK] 13

μ-LAW ——— [μ-LAW DIGITAL TRUNK] 14

DIGITAL SWITCH MODULE 10

CONTROL MEMORY 12

ENCODING LAWS CONVERSION MEMORY 11

## FIG.2

MULTIPLEXING DEVICE 20

PRIMARY TIME SWITCH 21

SPACE SWITCH 22

SECONDARY TIME SWITCH 23

ENCODING LAWS CONVERSION MEMORY 24

DEMULTIPLEXING DEVICE 25

CONTROL MEMORY 26

CONTROL MEMORY 27

CONTROL MEMORY 28

CONTROL MEMORY 29

SIGNAL RECEIVER AND DISTRIBUTOR 30

CONTROL UNIT 31

1

FIG.3

FROM SECONDARY TIME SWITCH

TO DEMULTIPLEXER

DELAY 24₁

B8
B7
B2
B1

A0
A1
A2
A6

D0
D1

B8
B7
B2
B1

32

PARITY ERROR

PARITY CHECK CIRCUIT

A7
A8
A11

D6

24

33

READ ADDRESS COUNTER

READ ADDRESS

34

SELECTOR

P | M₁ | M₀ | C₂ | C₁ | C₀

29

WRITE ADDRESS

WRITE CONTROL DATA

EP 0 165 462 B1

2

# FIG.4

ENCODING LAWS CONVERSION MEMORY
24

# FIG.5